Europäisches Patentamt

European Patent Office

Office européen des brevets

(11) Publication number: **0 221 773**
A2

# (12) EUROPEAN PATENT APPLICATION

(21) Application number: **86308448.9**

(22) Date of filing: **30.10.86**

(51) Int. Cl.⁴: **G 03 C 5/00**
**G 03 C 11/00, G 03 F 1/00**

(30) Priority: **31.10.85 GB 8526844**

(43) Date of publication of application:
**13.05.87 Bulletin 87/20**

(84) Designated Contracting States:
**AT BE CH DE FR GB IT LI NL SE**

(71) Applicant: **Esselte Letraset Limited**
**St. George's House 195-203 Waterloo Road**
**London SE1 8XJ(GB)**

(72) Inventor: **Shepherd, John Victor**
**48, Knatchbull Way**
**Brabourne Ashford Kent(GB)**

(74) Representative: **Marshall, Monica Anne et al,**
**GALLAFENT & CO. 8 Staple Inn**
**London WC1V 7QH(GB)**

(54) Opacifying phtographically produced images.

(57) Photographically produced images, preferably transfer images, of high opacity and consistent colouring, particularly when viewed against a dark background, are obtained by applying an opacifying layer containing water-soluble polymer, water-insoluble polymer and, generally white, pigment to the imagewise exposed and developed image on a release surface of a carrier. The opacifying layer is treated with water and is retained on the image areas and removed in remaining areas where it is in contact with the release surface. If necessary or desired adhesive is then applied to render the image transferable from the substrate. The opacifying layer itself may contain a permanent tack adhesive. Also the opacifying layer may itself be photosensitive and be imagewise exposed prior to the treatment with water. Then, in addition, to on the retained image areas, the opacifying layer is also retained in its exposed areas leading to interesting effects.

- 1 -

## OPACIFYING PHOTOGRAPHICALLY PRODUCED IMAGES

This invention relates to a method of increasing the opacity of photographically produced images, particularly transfer images.

Transfer materials, particularly in the form of dry transfer lettering sheets, are well known. Such lettering sheets comprise a carrier sheet having printed thereon, using a printing ink, transferable indicia. These indicia in use are transferred from the carrier sheet to the desired receptor surface. The production of such sheets by printing, usually screen printing, while economical for the production of large numbers of identical sheets, is cumbersome and expensive where small numbers or single transfers are required.

Where only small numbers or single transfer sheets are required, it is known to produce transfer sheets photographically whereby photosensitive material comprising a carrier sheet and a photosensitive layer is imagewise exposed and then developed by removal, e.g. by washing out, of non-image areas of the photosensitive layer to leave indicia on the carrier sheet. Such processes are for example described in British Patent Specifications Nos: 1291960 and 1364627 where, after development, adhesive is applied to the images formed to render them transferable from the carrier. According to British Patent Specifications Nos: 1441982 and 1521766 pressure-sensitive adhesive may be included in the photosensitive layer itself to render the images transferable without the necessity of applying a separate adhesive.

However the production of high opacity and consistently coloured photographically produced transfer images, particularly when viewed against a dark background, is difficult. For example the inclusion in a photographically sensitive layer of large amounts of pigment, as required to provide high opacity in the final image, is generally not possible since the presence of too much absorbing pigment prevents sufficient light reaching the photosensitive material on exposure. Also in such cases the final colour obtained will depend on the thickness of imaged material retained which in its turn is dependent on exposure times.

It is known to produce photographically white, and thus opaque, transfer images which are subsequently dyed to give the desired colour. Although the imaging steps are the same for each colour, the final colour achieved varies according to the dyeing and rinsing techniques used. It is generally found by this technique that the colours obtained are not well saturated making colour matching difficult.

It is known to improve the opacity of images by providing them with an opaque, generally white, layer. For example, this can be done in resist systems where an image is obtained by etching away unwanted material to leave the image areas. This is achieved by protecting the image areas by a previously exposed and developed photo resist, the non-image areas being unprotected and therefore etched away. If an opaque image is required, it is necessary to coat a white opaque layer over the coloured imaging layer prior to application of the photo resist. If a multi-coloured image is required, this has to be repeated for every colour.

It is also known to provide photosensitive material comprising a coloured photosensitive layer and an outer opacifying white layer itself photosensitive. When this material is imagewise exposed, sufficient imaging light must pass through the coloured photosensitive layer to the white photosensitive layer such that, in addition to the coloured layer, white layer material is hardened in the image areas and is retained during the development step. This method can produce images of sufficient opacity. However, in order to obtain hardening of the white layer, long exposure times are required. Also this method has the added disadvantage that each colour must have its own opaque white coat associated with it.

With sufficiently sensitive and colourless photosensitive systems, e.g. a carbonyl initiated system of GB 2009435B, it may be possible to provide for the inclusion of opacifying pigment or pigment mix in the photosensitive coating. Colours of good opacity and colour saturation can be produced in this way. However, if precise colour matching against a dark background is required, this method does not yield sufficiently consistent results. Also if the colour is not initially opaque, then this method does not yield opaque images.

According to the present invention there is provided a method of photographically producing an image which method comprises

imagewise exposing photosensitive material, the photosensitive material comprising a carrier sheet having a release surface which has thereon a photosensitive layer containing colouring material,

developing the image thereby obtained and, if necessary, drying the product,

applying over the image material obtained an opacifying layer comprising a water-soluble polymer, a water-insoluble polymer and a pigment, preferably white pigment, and

treating the product obtained with water and then drying.

The method of the present invention is particularly useful for producing opaque transfer images. In that case, if necessary or desired, there is subsequently applied adhesive to render the image transferable from the substrate.

If desired the opacifying layer itself may be photosensitive and be imagewise exposed prior to treatment with water.

It has been found that the opacifying layer material according to the present invention, when treated with water, is retained on the image areas and, where it is itself photosensitive, also in its exposed areas. The material is however removed in the remaining areas where it is in contact with the release surface of the carrier sheet. Thus there are obtained image areas having in register therewith an opacifying layer. Where the opacifying layer has itself been imagewise exposed then in addition the retained imaged layers of the opacifying layer can lead to interesting effects.

Thus, according to the present invention, the degree of opacity provided to the image is not dependent upon exposure time. This means that good colour matching against a dark background can be obtained. Moreover the rendering of the image obtained opaque can be carried out after all the imaging steps have been carried out. Thus a single opacifying coating according to the present invention can be used to opacify an already developed multi-coloured image.

A further advantage of the present invention is that, if the opacifying layer is made to contain a permanent tack adhesive, there are obtained directly transferable images provided with an in register adhesive.

Furthermore the presence of the opacifying layer may strengthen the image. Indeed, if desired ingredients to strengthen the image may be included.

The opacifying layer must be so formulated that, when treated with water, e.g. with a water spray, it is retained on the image areas while being washed off from the release surface in the non-image areas. This is achieved by the use of a mixture of a water-soluble polymer and a water-insoluble polymer. The precise proportions of the two polymers will depend upon their precise properties and on the nature of the image layer. Suitably the opaquing layer is formulated from a water-soluble polymer and a dispersion of the water-insoluble composition and the pigment which is coated onto the image material, e.g. using the usual Meyer bar coating technique, and then dried.

Examples of suitable water-soluble polymers for use in the compositions according to the present invention are polyvinyl alcohols, polyvinyl pyrrolidones and cellulose ethers e.g. hydroxy ethyl cellulose.

Examples of water-insoluble polymers dispersed in water which may be used are polyvinyl acetate copolymers, acrylate polymers, polyvinyl chloride and polyvinylidene chloride.

Any suitable pigment in opacifying amount may be used. Particularly preferred is the white pigment titanium dioxide.

The opacifying layer composition can contain solvents to improve the adhesion of the layer to the image. Examples of suitable solvents here are methanol, ethanol, methyl ethyl ketone, di-n-butyl oxalate.

Surface active agents can also be used in the layer to ensure stability of the composition.

In addition shear agents such as silica and acrylic monomers can be added to the opacifying formulation to improve the imagewise wash-out characteristics of the layer.

When the opacifying layer is itself photosensitive there is preferably used a low colour initiator (e.g. a carbonyl initiator as described in GB 2009435B). The use of coloured initiators make colour matching more difficult. The initiator is suitably used with an amine promoter and unsaturated monomer.

The photosensitive material used according to the present invention comprises a carrier sheet having a release surface which has thereon a photosensitive layer containing colouring material.

The carrier sheet used may be any convenient flexible material having a release surface. A wide variety of such carrier sheets is already known and used, for example, in the manufacture of various dry transfer materials. Release coated papers may be used. However, to obtain accurate positioning of dry transfer material on a receptor surface, it is desirable that the carrier sheet should be light transmitting i.e. transparent or translucent so that the receptor surface is visible through the transfer at the moment of transfer. Suitable such carrier materials include transparent or translucent plastics films, e.g. polyethylene, polystyrene or polyethylene terephthalate, coated, where appropriate, to provide the required release properties.

The photosensitive layer suitably contains dye and/or pigment as colouring material. The photosensitive layer is preferably photopolymerisable and/or photocrosslinkable whereby, after imagewise exposure, the layer may be developed to remove non-photopolymerised or non-photocrosslinked photosensitive layer material in the non-image areas. For convenience there is preferably used a water-developable photosensitive layer.

The invention is further illustrated in the following Examples. In the Examples parts and percentages are by weight unless otherwise indicated.

## EXAMPLE 1

There was prepared a silicone release coating

composition as follows:

| | Parts |
|---|---|
| Silicone polymer-containing catalyst (Syl-off 7046 ex Dow Corning) | 20.5 |
| Crosslinking agent (Syl-off 7048 ex Dow Corning) | 0.102 |
| Adhesion promoter (Syl-off Q2-7089 ex Dow Corning) | 0.92 |
| Hydrocarbon solvent (Exsol 145/160 ex Esso) | 14.24 |
| Methyl ethyl ketone | 14.24 |

This composition was coated onto polyethylene terephthalate (542 Melinex ex I.C.I.) using a No. 72 Meyer bar and cured at 120°C for 5 minutes.

There were prepared the following starting mixtures:

A 30% polyvinyl alcohol solution in water was prepared using Gohsenol GL03 (ex Nippon Gohsei).

A dispersion of 30% silica (Neosyl GP ex Crossfield Ltd) in a 10% solution of the polyvinyl alcohol (Gelvatol 4020 ex Monsanto Limited) was prepared by the simple addition of the silica to the solution with mixing.

A mixture of surface active agents was made by adding Tween 80 (62%) to Span 80 (38%) (both ex Honeywell and Stein) and mixing the two liquids to homogeneity.

A solution of the initiator isopropyl thioxanthone (Quantacure ITX ex Ward Blenkinsop) in the amine 2-butoxyethyl-4-(dimethyl amino)-benzoate (Quantacure BEA ex Ward Blenkinsop) in the ratio 1:2 was made by mixing the initiator into the amine heated to about 50°C.

A dispersion of Monastral Blue BG in 10% polyvinyl alcohol solution (Gelvatol 4020) was made by adding 30 parts of the Monastral Blue pigment to 70 parts of the solution and ball milling for 48 hours.

A photosensitive coating composition was prepared by mixing together the following ingredients using a high

shear stirrer.

|  | Parts |
|---|---|
| Acrylate monomer (AM548 ex Synthese BV) | 22 |
| 30% polyvinyl alcohol solution | 60 |
| Initiator in amine mixture | 4.2 |
| Silica in polyvinyl alcohol dispersion | 27.6 |
| Surface active agents mixture | 13.8 |
| Polyvinyl acetate copolymer dispersion (Emultex 592 ex Harco) | 34.02 |
| Polyvinyl acetate homopolymer dispersion (Vinnapas D50NK ex Wacker Chemie) | 56.7 |
| Monastral Blue dispersion | 2.0 |

This mixture was coated using a No. 15 Meyer bar over the silicone release coat and dried at 50°C.

The photosensitive material thereby obtained was exposed to light from a 2kw mercury metal halide discharge lamp through a photographic negative for 30 seconds. The resulting image was developed by washing with water and the sheet was then dried. There was obtained a sheet having transparent blue transferable image areas thereon. The sheet obtained in this way was used in the following Examples to demonstrate the use of opaquing compositions.

### EXAMPLE 2

The following starting mixtures were prepared:

A dispersion of titanium dioxide (Tiona 472 ex Laport) in a 13% solution of hydroxyethyl cellulose (Natrasol 250 L ex Hercules Powder) was prepared by adding the ingredients together at a ratio of 1:1 and mixing using a high shear stirer.

A 10% solution of the surface active agent Aerosol OT (ex Hopkin and Williams) was prepared in water.

An opaquing composition was prepared as follows:

| | Parts |
|---|---|
| Titanium dioxide dispersed in hydroxyethyl cellulose | 10 |
| 13% solution of hydroxyethyl cellulose (Natrasol 250 L) in water | 7 |
| 10% solution of Aerosol OT | 4 |
| Polyvinylidine chloride dispersion (Polidene 33-004 ex Scott Bader) | 4.5 |

This composition was mixed to give an even dispersion. The composition was coated on to the transparent blue images obtained on the sheet of Example 1 using a No. 10 Meyer bar and then dried.

The resulting sheet was then washed with water. The opaquing layer was retained in full film thickness over the images whilst it was washed off from the silicone release coat in the non-image areas.

The images thus obtained, when provided with dry transfer adhesive, gave transferable opaque images.

## EXAMPLE 3

The following starting mixture was prepared:

A dispersion of titanium dioxide (Tiona 472 ex Laport) in 10% polyvinyl alcohol solution (Gelvatol 4020) was prepared by ball milling 60 parts of the titanium dioxide pigment in 40 parts of the solution for 24 hours.

An opaquing composition was prepared as follows:

| | Parts |
|---|---|
| 30% polyvinyl alcohol solution (as in Example 1) | 193 |
| Acrylate monomer (AM548) | 15 |
| Silicone acrylate monomer (Ebecryl 350 ex UCB BV) | 4.7 |
| Silica in polyvinyl alcohol dispersion (as in Example 1) | 15 |

|                                          | Parts |
| ---------------------------------------- | ----- |
| Surface active agents mixture (as in Example 1) | 7 |
| Polyvinyl acetate copolymer dispersion (Emultex AC43 ex Harco) | 87 |
| Polyvinyl acetate copolymer dispersion (Vinnapas MV70H ex Wacker Chemie) | 82 |
| 10% solution of Aerosol OT (as in Example 2) | 170 |
| Surface active agent (Silwett 7001 ex Union Carbide) | 14.6 |
| Dispersion of titanium dioxide in polyvinyl alcohol | 223 |

This composition was stirred to give an even dispersion.

The composition was coated onto the sample sheet of transparent blue images of Example 1 using a No. 20 Meyer bar and dried.

The resulting sheet was then washed with water. The opaquing layer was retained with full film thickness over the images whilst being removed from the non-image areas.

## EXAMPLE 4

An opaquing composition was prepared as follows:

|                                          | Parts |
| ---------------------------------------- | ----- |
| Opaquing composition of Example 3 | 100 |
| 10% solution of Aerosol OT (as in Example 2) | 20 |
| Polyvinyl acetate pressure sensitive adhesive (Mowilith DM 45 ex Harco) | 20 |

The composition was stirred to given an even composition.

This opaquing composition was coated on to the sample sheet of transparent blue images of Example 1, dried and washed as in Example 3. There was obtained a dry transfer sheet bearing indicia of high tack.

## EXAMPLE 5

The following starting compositions were prepared:

Initiator mixture A comprising Daracure 1664 (ex Merck) and the amine 2-(dimethyl amino) ethyl benzoate (Quantacure DMB ex Ward Blenkinsop) in the ratio 1:1.

Initiator mixture B of the initiator Quantacure ITX in the amine Quantacure DMB in the ratio 1:1 was prepared by adding the solid initiator to the amine and heating to about 50°C.

An opaquing formulation was prepared as follows:

|  | Parts |
|---|---|
| 30% polyvinyl alcohol solution (as in Example 1) | 30 |
| Acrylate (AM 548) | 15.2 |
| Silicone acrylate monomer (Ebecryl 350) | 4.7 |
| Silica in polyvinyl alcohol dispersion (as in Example 1) | 108 |
| Initiator mixture A | 4 |
| Initiator mixture B | 5 |
| Surface active agents mixture (as in Example 1) | 7 |
| Polyvinyl acetate homopolymer (Vinnapas D50NK) | 95 |
| Polyvinyl acetate homopolymer (Mowilith DHL ex Harco) | 38 |
| Polyvinyl acetate copolymer dispersion (Emultex AC43) | 87 |
| Polyvinyl acetate copolymer dispersion (Vinnapas MV70H) | 82 |
| 10% solution of Aerosol OT (as in Example 2) | 10 |

Parts

Surface active agent
(Silwett 7001)                                14.6
Dispersion of titanium dioxide
in polyvinyl alcohol solution
(as in Example 3)                            60

The above ingredients were stirred under high shear to produce a homogeneous dispersion. The dispersion was coated onto the sample sheet of transparent blue images of Example 1 using a No. 10 Meyer bar and the coating was dried.

On washing with water, the opaquing layer washed off in the non-image areas but was retained at full film thickness in the image areas.

If required, before washing with water, the white layer could be itself imagewise exposed to UV light. Then, after washing, the white layer would be retained in both the exposed areas and on the blue image areas. This allows for a variety of decorative effects to be produced.

## CLAIMS

1. A method of photographically producing an image which method comprises

imagewise exposing photosensitive material, the photosensitive material comprising a carrier sheet having a release surface which has thereon a photosensitive layer containing colouring material,

developing the image thereby obtained and, if necessary, drying the product, characterised by

applying over the image material obtained an opacifying layer comprising a water-soluble polymer, a water-insoluble polymer and a pigment, and

treating the product obtained with water and then drying.

2. A method according to claim 1 for producing a transferable image characterised in that, if necessary or desired, there is subsequently applied adhesive to render the image transferable from the substrate.

3. A method according to claim 1 characterised in that the opacifying layer contains a permanent tack adhesive.

4. A method according to claim 1 characterised in that the opacifying layer itself is photosensitive and is imagewise exposed prior to treatment with water.

5. A method according to claim 1 characterised in that the opacifying layer contains white pigment.

6. A method according to claim 1 characterised in that the water-soluble polymer is a polyvinyl alcohol, polyvinyl pyrrolidone or cellulose ether.

7.    A method according to claim 1 characterised in that the water-insoluble polymer is a polyvinyl acetate copolymer, acrylate polymer, polyvinyl chloride or polyvinylidene chloride.